# EUROPEAN PATENT SPECIFICATION

(11) **EP 0 330 356 B1**
(45) Date of publication and mention of the grant of the patent: **24.11.1993**
(21) Application number: 89301352.4
(22) Date of filing: 13.02.1989
(51) Int. Cl.: G11B 5/66, C23C 14/16

(54) **A thin film magnetic medium and method of producing same**
Magnetisches Dünnschichtmedium und Verfahren zu seiner Herstellung
Milieu magnétique en couche mince et procédé de sa production

(30) Priority: 25.02.1988 US 160056
(43) Date of publication of application: 30.08.1989
(73) Proprietor: International Business Machines Corporation, Armonk, N.Y. 10504 (US)
(72) Inventor: Edmonson, David Alvoid, Rochester, MN 55901 (US); Ivett, Peter Robert, Totton Hampshire S04 4BN (GB); Johnson, Kenneth Edmund, Rochester, MN 55904 (US); Mirzamaani, Seyyed Mohammad Taghi, Croton-on-Hudson New York 10520 (US); Ward, James Francis, Jr., Rochester, MN 55902 (US)
(74) Representative: Moss, Robert Douglas

(56) References cited:
- EP-A- 0 243 672
- DE-A- 3 601 848

## Description

### Technical Field of the Invention

The invention pertains to a thin film cobalt alloy magnetic medium and more particularly to structure and method of fabrication of the medium.

### Background of the Invention

The use of thin film cobalt alloy magnetic media in magnetic disks is well known. In seeking higher areal recording densities on rigid magnetic disk surfaces, it is known that thin film media has significant advantages over particulate disk media technology. Thin film media have higher remanence (Mr) values, the measure of the magnetic strength of the material, because there is no dilution of magnetization by non-magnetic polymer binders. Further, magnetic films are naturally stronger magnetic materials than the oxide particles used in particulate films.

Producing a good thin film magnetic disk involves more than depositing a uniform thickness metallic, magnetic layer. Magnetic anisotropy (the tendency for a material to magnetize in a specific direction) must be rigidly controlled. If this is not done, degrading effects such as modulation in the readback signal can occur. One of the keys to producing a suitable magnetic film for longitudinal recording is to assure that the magnetic anisotropy is in plane. To optimize use of the in plane orientation it is further necessary to have the magnetic orientation random or circumferential as well as in plane to overcome signal variation or modulation during disk rotation. This preferential horizontal alignment is necessary to produce high squareness hysteresis curves, the squareness of the media being a measure of the magnetic quality of the magnetic layer. Large values, approaching unity, are desirable, indicating the potential for high signal strength and short transitions. The squareness (S) is determined by the magnetic layer material system selected and by the orientation of the easy axis of magnetisation.

EP-A-0,243,672 discloses magnetic media for horizontal recording in which an underlayer of a chromium based alloy is formed between the substrate and the cobalt based magnetic layer. The composition of the chromium alloy underlayer is chosen to achieve improved lattice matching between underlayer and magnetic layer thereby giving enhanced squareness.

### Disclosure of the Invention

To optimise the magnetic properties of the thin film cobalt alloy media for horizontal recording, the invention provides a thin film magnetic recording medium comprising: a rigid non-ferromagnetic substrate; a chromium underlayer; and a ferromagnetic thin film cobalt alloy magnetic coating epitaxially grown from the chromium underlayer; characterised in that: the chromium underlayer has a thickness of between 5 and 20 nm (50 and 200 Angstroms) with the (1,0,0) plane of its body centred cubic structure parallel to the recording surface; and the thin film cobalt alloy is attached to the underlayer by its (110) plane such that the cobalt alloy hexagonal close packed atomic structure has its C axis substantially parallel to the recording surface.

It is preferred that the rigid non-ferromagnetic substrate comprises an aluminium disk having a coating of relatively harder material with a surface smoothness such that asperities do not exceed 4 nm (40 angstroms). It is further preferred that the hard material surface includes substantially concentric circular grooves not exceeding 10 nm (100 angstroms) in depth whereby the atomic structure of said chromium and ferromagnetic thin films are induced to be deposited with the ferromagnetic thin film easy axis of magnetisation aligned in the circumferential direction. This alignment has the effect of optimising the magnetic characteristics and avoiding modulation of the readback signal.

Preferably, the thin film recording medium further comprises a sputtered protective coating overlying the ferromagnetic thin film cobalt alloy magnetic coating. It is further preferred that the composition of the thin film cobalt alloy coating is cobalt-platinum-chromium including at least 70 atomic percent cobalt. The magnetic coating could be composed of alternative alloys such as cobalt-platinum.

The invention also provides a method of making such a thin film recording medium comprising the steps of preparing a non-ferromagnetic substrate to provide a substantially smooth surface; sputter depositing a chromium layer of 5 to 20 nm (50 to 200 angstroms) thickness on said substrate surface at a rate of at least 100 nm (1000 angstroms) per minute and at a temperature in excess of 150 degrees Celsius; and without exposing the chromium layer to the atmosphere, sputter depositing a ferromagnetic thin film coating of cobalt alloy that is epitaxially grown from said chromium layer with the easy axis of magnetisation parallel to said surface.

Preferably, the step of sputter depositing a chromium layer and the step of sputter depositing a ferromagnetic thin film coating occur as consecutive steps in a single sputtering apparatus.

It is further preferred that the method further comprises the step of sputter depositing a protective coating over said ferromagnetic thin film coating within said single sputtering apparatus whereby said three sputter deposition steps occur within said apparatus without removal of the disk substrate from the atmosphere of the sputter processing chamber.

It is preferred that the step of preparing the substrate comprises applying a hard material coating, preferably nickel phosphorus, to an aluminium substrate and polishing said hard material coating to a surface finish with a maximum roughness of 4 nm (40 angstroms) RMS.

Preferably, the finished surface of the hard material is textured by imparting substantially concentric grooves that are radially spaced and which do not exceed 10 nm (100 angstroms) in depth.

### Brief Description of the Drawing

Figure 1 is a section view of a magnetic film medium according to the present invention.

Figure 2 is a schematic representation of the hexagonal close packed structure of a cobalt alloy incorporated in the present invention.

Figure 3 is a schematic illustration showing the atoms at the interface between chromium underlayer (100) plane and the cobalt media (110) plane.

Figure 4 is a graph showing squareness as a function of chromium underlayer thickness which is obtained practising the present invention.

### Detailed Description

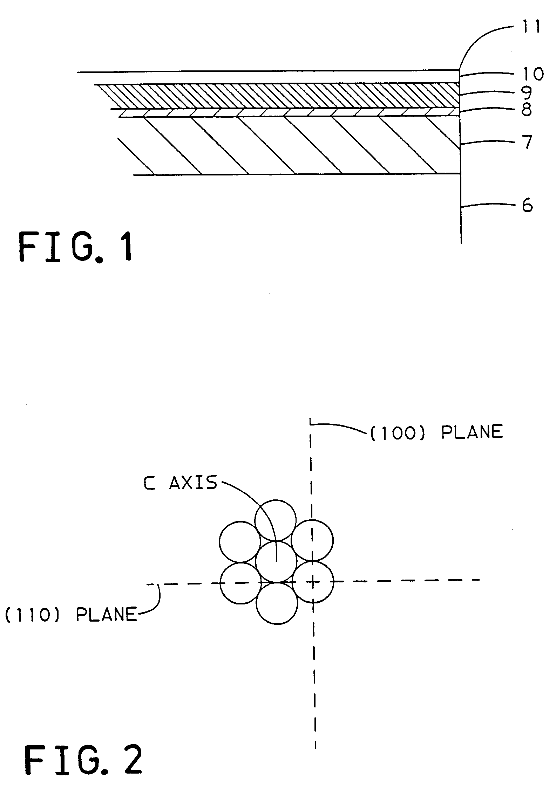

Figure 1 shows a section view of the thin film magnetic medium of the present invention, in the form of a disk. As in substantially all current rigid disk products, the disks magnetic coating is placed over an aluminium alloy substrate 6. In a typical disk having a 130 mm outside diameter the substrate has a thickness of 1.9 mm. The initial layer overlying the substrate is a deposit of hard nickel-phosphorous (NiP) 7 which is electroless plated over the aluminium surface. The surface thus provided is equivalent in hardness to carbon steel (600 kg/mm²) and serves as a firm base for the very thin and fragile magnetic layer. In addition, the NiP allows the creation of a very smooth and controlled surface finish via abrasive processing that a soft aluminium surface alone could not provide. The surface morphology of the polished NiP is replicated by succeeding layers of the disk structure. The final disk surface must be free of asperities to allow recording heads to fly close and to minimise head disk interactions that can accelerate disk wear.

The NiP layer on the aluminium substrate is first polished to a high degree of smoothness 4 nm (40 angstroms) RMS. Optionally, a circumferential texture may be imparted to the NiP surface (6.5 nm (65 angstroms) RMS measured radially) which serves to reduce stiction and friction while at the same time improving magnetic properties due to preferential grain alignment along the circumferential grooves. Even with the added surface texture, the resultant disk surface uniformity and roughness still allows a recording head to fly at 0.178 µm (seven microinches) at the inner diameter without encountering interference or interactions.

Following the preparation of the NiP surface, a chromium underlayer 8, a ferromagnetic cobalt alloy magnetic layer 9 and a protective over coating 10 are sequentially applied by sputter deposition within a single sputtering apparatus. The entire process can be accomplished using an inline process where a vertical pallet supporting multiple disks is sputtered over the course of several minutes to produce a large quantity of disks at low cost with very uniform film thicknesses and magnetic properties. After emerging from the sputtering step, a lubricant organic monolayer 11 is deposited in specially designed equipment under tightly controlled temperature conditions.

To produce a thin film disk for high density recording it is not in itself sufficient to apply a uniform smooth film of ferromagnetic recording material. The atoms of the recording material layer must be oriented with the easy axis of magnetisation parallel to the surface of the disk in devices that use horizontal recording. This presents some difficulty when using cobalt alloy recording materials since the c axis of the hexagonal close packed molecule structure is prone to position vertically rather than horizontally during most material application techniques.

It has been found that by applying a thin underlayer of chromium with the (100) (one, zero, zero) plane at the surface upon which the ferromagnetic cobalt alloy recording material is to be applied, conditions can be controlled to cause the cobalt alloy (110) (one, one, zero) plane to attach to the (100) plane of the chromium underlayer. This disposes the cobalt alloy c axis or axis of easy magnetisation parallel to the disk surface, in the optimum orientation for horizontal recording. As shown in Fig 2, the hexagonal close packed configuration of the cobalt alloy ferromagnetic material has a central atom surrounded by six atoms in a tightly proximate relation. The c axis is perpendicular to the figure at the centre point as shown. This is the axis of easiest magnetization. The c axis can be positioned in the desired horizontal orientation by having the cobalt alloy structure attach to the chromium underlayer along the (100) or (110) planes, which are planes vertical to the figure through the broken lines indicated. The (100) plane will not combine with the chromium underlayer to form a planar c axis orientation. The spacing of the cobalt alloy atoms will not align with the (100) plane of the chromium atoms to afford epitaxial growth of the cobalt alloy crystal structure. However, the (110) plane of the cobalt alloy presents an atomic spacing almost ideally matched to the (100) surface of the chromium underlayer.

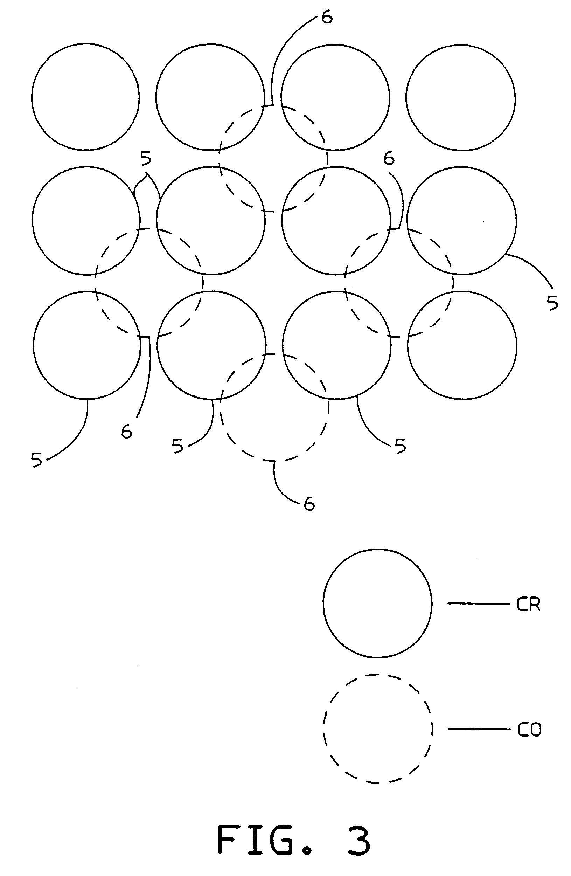

Fig. 3 is a schematic showing of the interface between the thin film chromium underlayer and the cobalt alloy magnetic thin film. The chromium atoms (solid line circles 5) at the underlayer surface, have a pattern as shown when the (100) is presented. The hexagonal close packed cobalt atomic structure with the (110) planes parallel to the paper fit well into the interstitial locations of the chromium (100) surface as shown by the broken line circles 6. Thus the formation of a chromium film with the atomic (100) planes parallel to the exposed surface induces epitaxial growth of the cobalt magnetic material with the (110) plane parallel to the media surface to place the C axis or easy axis of magnetization parallel to the media surface.

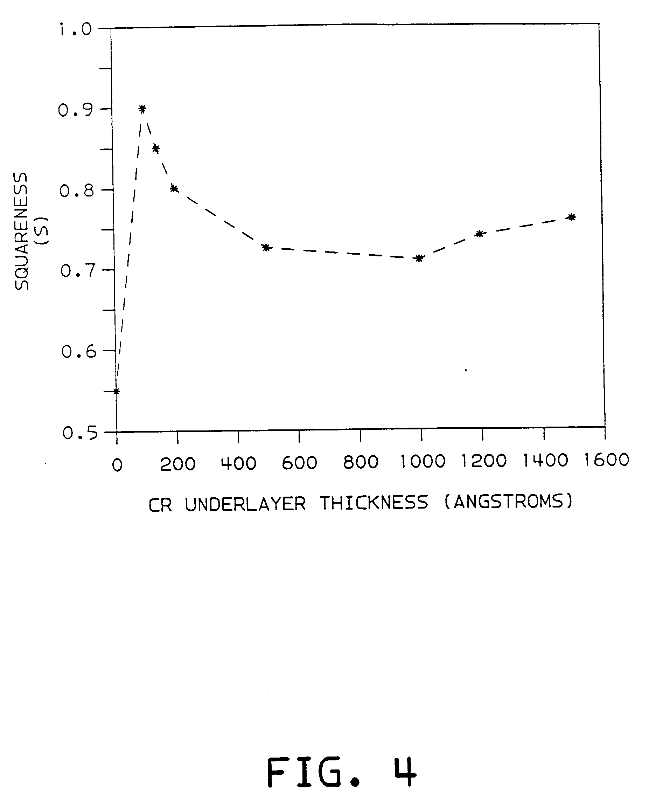

It has been found that by sputtering the chromium underlayer at a high rate of 100 to 400 nm (1000 to 4000 angstroms) per minute and at an elevated temperature of >150 degrees Celsius to produce a thickness of 50 to 200 angstroms, the chromium underlayer will be deposited with the desired (100) plane at the underlayer surface. As seen in the graph of Fig 4, the maximum amount of squareness occurs with the use of an underlayer thickness within the 50 to 200 angstrom range. With thicker layers the chromium crystal structure tends to randomize and favour other planes in addition to the (100).

The ferromagnetic cobalt alloy recording layer is then sputter deposited within the same apparatus without exposure to the atmosphere which can alter the chromium atomic orientation or chemically change the chromium underlayer by oxidization. The sputtered ferromagnetic layer grows epitaxially with the C axis, the easy axis of magnetization parallel to the surface of the disk. Upon completing application of the thin film recording layer, the protective coating is also applied within the same apparatus. However, since the protective coating effectiveness is not dependent upon atomic orientation, the conditions of application are not as demanding as those of the magnetic recording film and the chromium underlayer.

In a longitudinal recording system, it is not only beneficial that the easy axis of magnetization be in plane and parallel to the recording surface, but also be circumferentially oriented to optimize the recording capabilities. The circumferential orientation can be enhanced by texturing the disk recording surface. The unsputtered, hard surfaced, polished substrate is provided with concentric, circular microgrooves to provide a flat polished planar land surface that is interrupted periodically by circumferential grooves. The planar surface is polished or finished to a smoothness wherein the asperities do not exceed 4 nm (40 angstroms). The grooves that afford the texturing have a depth not exceeding 10 nm (100 angstroms), with the average depth less than 9 nm (90 angstroms).

The texturing that affords other benefits also forms a part of the surface that is replicated by the sputtered chromium and thin film magnetic media coatings and influences the deposition of the epitaxially grown magnetic layer to induce a circumferential orientation of the magnetic domain easy axis of magnetization.

## Claims

1. A thin film magnetic recording medium comprising:
a rigid non-ferromagnetic substrate (6, 7);
a chromium underlayer (8); and
a ferromagnetic thin film cobalt alloy magnetic coating (9) expitaxially grown from the chromium underlayer; characterised in that:
the chromium underlayer has a thickness of between 5 and 20 nm (50 and 200 Angstroms) with the (1,0,0) plane of its body centred cubic structure parallel to the recording surface; and
the thin film cobalt alloy is attached to the underlayer by its (110) plane such that the cobalt alloy hexagonal close packed atomic structure has its C axis substantially parallel to the recording surface.

2. A thin film recording medium as claimed in claim 1 wherein the rigid non-ferromagnetic substrate comprises an aluminium disk (6) having a coating of relatively harder material (7) with a surface smoothness such that asperities do not exceed 4nm (40 angstroms).

3. A thin film recording medium as claimed in claim 2 wherein the harder material surface includes substantially concentric circular grooves not exceeding 10 nm (100 angstroms) in depth.

4. A thin film recording medium as claimed in claim 2 or claim 3 where the relatively harder material is nickel-phosphorous.

5. A thin film recording medium as claimed in any of the preceding claims further comprising a sputtered protective coating (10) overlying the ferromagnetic thin film cobalt alloy magnetic coating.

6. A thin film recording medium as claimed in any preceding claim wherein the thin film cobalt alloy coating is cobalt-platinum-chromium including at least 70 atomic percent cobalt.

7. A method of making a thin film magnetic recording medium comprising
preparing a non-ferromagnetic substrate (6, 7) to provide a substantially smooth surface;
sputter depositing a chromium layer (8) of 5 to 20 nm (50 to 200 angstroms) thickness on said substrate surface at a rate of from 100 nm (1000 angstroms) to 400 nm (4000 angstroms) per minute and at a temperature in excess of 150 degrees Celsius; and without exposing the chromium layer to the atmosphere,
sputter depositing a ferromagnetic thin film coating of cobalt alloy (9) that is epitaxially grown from said chromium layer with the easy axis of magnetisation parallel to said surface.

8. A method of making a thin film magnetic recording medium as claimed in claim 7, wherein the step of sputter depositing a chromium layer and the step of sputter depositing a ferromagnetic thin film coating occur as consecutive steps in a single sputtering apparatus.

9. A method of making a thin film magnetic recording medium as claimed in claim 8 further comprising the step of sputter depositing a protective coating (10) over said ferromagnetic thin film coating within said single sputtering apparatus whereby said three sputter deposition steps occur within said apparatus without removal of the substrate from the atmosphere of the sputter processing chamber.

10. A method of making a thin film magnetic recording medium as claimed in any of claims 7 to 9 wherein said step of preparing a substrate comprises applying a harder material coating (7) to an aluminium substrate (6) and polishing said harder material coating to a surface finish with a maximum roughness of 4 nm (40 angstroms) RMS.

11. A method of making a thin film magnetic recording medium as claimed in claim 10 further comprising the step of texturing the finished surface of said harder material coating by imparting substantially concentric grooves that are radially spaced and which do not exceed 10 nm (100 angstroms) in depth.

12. A method of making a thin film magnetic recording medium as claimed in claim 10, wherein the step of applying a hard material coating comprises the application of a nickel-phosphorous layer to the surface of the aluminium substrate.

## Patentansprüche

1. Ein magnetisches Dünnschicht-Aufzeichnungsmedium, das folgendes umfaßt:
ein starres, nicht ferromagnetisches Substrat (6, 7);
eine Chrom-Unterschicht (8); und
eine ferromagnetische mit Kobalt legierte Dünnschicht-Magnetbeschichtung (9), die epitaxial aus der Chrom-Unterschicht gezüchtet wurde; dadurch gekennzeichnet, daß:
die Chrom-Unterschicht eine Dicke zwischen 5 und 20 nm (50 und 200 Angström) aufweist, und die Ebene (1,0,0) ihrer raumzentrierten kubischen Struktur parallel zur Aufzeichnungsfläche liegt; und
die Dünnschicht-Kobaltlegierung an der Unterschicht mit ihrer Ebene (110) angelagert wird, so daß die C-Achse der hexagonalen dicht gepackten atomaren Struktur der Kobaltlegierung im wesentlichen parallel zur Aufzeichnungsfläche ausgerichtet ist.

2. Ein Dünnschicht-Aufzeichnungsmedium nach Anspruch 1, in dem das starre nicht ferromagnetische Substrat eine Aluminiumplatte (6) mit einer Beschichtung aus einem relativ härteren Material (7) umfaßt, mit einer Oberflächengüte, deren Rauhtiefe 4 nm (40 Angström) nicht überschreitet.

3. Ein Dünnschicht-Aufzeichnungsmedium nach Anspruch 2, bei dem die härtere Materialoberfläche im wesentlichen konzentrische kreisförmige Rillen aufweist, deren Tiefe 10 nm (100 Angström) nicht überschreitet.

4. Ein Dünnschicht-Aufzeichnungsmedium nach Anspruch 2 oder Anspruch 3, bei dem das relativ härtere Material Nickel-Phosphor ist.

5. Ein Dünnschicht-Aufzeichnungsmedium nach einem der vorangehenden Ansprüche, welches desweiteren eine gesputterte Schutzbeschichtung (10) über der ferromagnetischen mit Kobalt legierten Dünnschicht-Magnetbeschichtung aufweist.

6. Ein Dünnschicht-Aufzeichnungsmedium nach einem der vorangehenden Ansprüche, in dem die mit Kobalt legierte Dünnschichtbeschichtung aus Kobalt-Platin-Chrom besteht und mindestens 70 Atomprozent Kobalt enthält.

7. Eine Methode zur Herstellung eines magnetischen Dünnschicht-Aufzeichnungsmediums, die folgendes umfaßt:
Vorbereiten eines nicht ferromagnetischen Substrats (6, 7) zur Bildung einer im wesentlichen glatten Oberfläche;
Aufsputtern einer Chrom-Schicht (8) von 5 bis 20 nm (50 bis 200 Angström) Dicke auf der genannten Substrat-Oberfläche mit einer Geschwindigkeit von 100 nm (1000 Angström) bis 400 nm (4000 Angström) pro Minute und einer Temperatur über 150 Grad Celsius und ohne die Chrom-Schicht der Atmosphäre auszusetzen;
Aufsputtern einer ferromagnetischen, mit Kobalt legierten Dünnschicht-Beschichtung (9), die epitaxial aus der genannten Chrom-Schicht gezüchtet wird, deren bevorzugte Magnetisierungsrichtung parallel zu der genannten Oberfläche liegt.

8. Eine Methode zur Herstellung eines magnetischen Dünnschicht-Aufzeichnungsmediums nach Anspruch 7, bei der das Aufsputtern einer Chrom-Schicht und das Aufsputtern einer ferromagnetischen Dünnschicht-Beschichtung als aufeinanderfolgende Schritte in einer einzigen Sputtereinrichtung erfolgen.

9. Eine Methode zur Herstellung eines magnetischen Dünnschicht-Aufzeichnungsmediums nach Anspruch 8, desweiteren den Schritt des Aufsputterns einer Schutzbeschichtung (10) über der genannten ferromagnetischen Dünnschicht-Beschichtung innerhalb der genannten einzelnen Sputtereinrichtung umfassend, wodurch die drei genannten Aufsputterungsschritte in der genannten Einrichtung ohne Herausnahme des Substrats aus der Atmosphäre der Sputterkammer stattfinden.

10. Eine Methode zur Herstellung eines magnetischen Dünnschicht-Aufzeichnungsmediums nach einem der Ansprüche 7 bis 9, bei der der genannte Schritt der Vorbereitung eines Substrats das Aufbringen einer härteren Materialschicht (7) auf ein Aluminium-Substrat (6) und das Polieren der genannten härteren Materialschicht umfaßt, bis eine Oberflächengüte mit einer maximalen Rauhtiefe von 4 nm (40 Angström) RMS erreicht ist.

11. Eine Methode zur Herstellung eines magnetischen Dünnschicht-Aufzeichnungsmediums nach Anspruch 10, die desweiteren den Schritt der Texturierung der fertigen Oberfläche der genannten härteren Materialschicht umfaßt, durch Ausstattung mit im wesentlichen konzentrischen Rillen, die einen radialen Abstand zueinander aufweisen, und deren Tiefe 10 nm (100 Angström) nicht überschreitet.

12. Eine Methode zur Herstellung eines magnetischen Dünnschicht-Aufzeichnungsmediums nach Anspruch 10, bei der der Schritt des Auftragens einer Hartmaterialschicht das Auftragen einer Nickel-Phosphor-Schicht auf die Oberfläche des Aluminium-Substrats umfaßt.

## Revendications

1. Support d'enregistrement à film mince comprenant :
- un substrat non ferro-magnétique rigide (6, 7) ;
- une couche sous-jacente (8) de chrome ; et
- une couche magnétique d'alliage de cobalt en film mince ferro-magnétique (9) obtenue par croissance épitaxiale à partir d'une couche sous-jacente de chrome ; caractérisée en ce que :
la couche sous-jacente de chrome a une épaisseur comprise entre 5 et 20 nm (50 et 200 angstroms) et dont le plan (1, 0, 0) de sa structure cubique centrée soit parallèle à la surface d'enregistrement ; et
l'alliage de cobalt en film mince est attaché à la couche sous-jacente selon son plan (110) de sorte que la structure atomique hexagonale très condensée d'alliage de cobalt ait un axe C pratiquement parallèle à la surface d'enregistrement.

2. Support d'enregistrement à film mince selon la revendication 1 dans lequel le substrat non ferro-magnétique rigide comprend un disque d'aluminium 6 recouvert d'une couche de matériau plus dur (7) dont la surface lisse présente des aspérités ne dépassant pas 4 mn (40 angstroms).

3. Support magnétique à film mince selon la revendication 2 dans lequel la surface de matériau plus dur comporte des rainures circulaires concentriques dont la profondeur ne dépasse pas 10 nm (100 angstroms).

4. Support d'enregistrement magnétique selon la revendication 2 ou 3 dont ledit matériau plus dur est constitué par du nickel phosphoreux.

5. Support d'enregistrement magnétique selon l'une quelconque des revendications précédentes comprenant en outre une couche protectrice pulvérisée (10) recouvrant la couche magnétique d'alliage de cobalt en film mince ferro-magnétique.

6. Support d'enregistrement magnétique à film mince selon l'une quelconque des revendications précédentes dans lequel la couche d'alliage de cobalt en film mince est constituée par du cobalt platine et chrome comprenant au moins 70 % d'atomes de cobalt.

7. Procédé de fabrication d'un support d'enregistrement magnétique à film mince comprenant :
préparation d'un substrat non ferro-magnétique (6, 7) permettant d'obtenir une surface pratiquement lisse ;
dépôt par pulvérisation d'une couche de chrome (8) de 5 à 20 nm (50 à 200 angstroms) d'épaisseur, sur ladite surface du substrat à un taux de 100 nm (1000 angstroms) à 400 nm (4000 angstroms) par minute et à une température dépassant 150 degrés Celsius ; sans exposition de la couche de chrome à l'atmosphère,
dépôt par pulvérisation d'une couche de film mince ferro-magnétique en alliage de cobalt (9) obtenue par croissance épitaxiale à partir d'une couche de chrome et dont l'axe de facile aimantation est parallèle à ladite surface.

8. Procédé de fabrication d'un support d'enregistrement magnétique à film mince selon la revendication 7, dans lequel l'étape de dépôt par pulvérisation d'une couche de chrome et l'étape de dépôt par pulvérisation de la couche de film mince ferro-magnétique se produisent consécutivement dans un même dispositif de pulvérisation.

9. Procédé de fabrication d'un support d'enregistrement magnétique à film mince selon la revendication 8 comprenant en outre l'étape de dépôt par pulvérisation d'une couche protectrice (10) sur ladite couche de film mince ferro-magnétique dans ledit dispositif de pulvérisation les trois étapes de dépôt par pulvérisation étant réalisées dans un même dispositif sans enlèvement du substrat de l'atmosphère de la chambre de pulvérisation.

10. Procédé de fabrication d'un support d'enregistrement magnétique à film mince selon l'une des revendications 7 à 9 dans lequel ladite étape de préparation du substrat comprend l'application d'une couche de matériau plus dur (7) sur un substrat d'aluminium (6) et le polissage de ladite surface de matériau plus dur, pour obtenir une surface dont la rugosité ne dépasse pas 4 nm (40 angstroms).

11. Procédé de fabrication d'un support d'enregistrement magnétique à film mince selon la revendication 10 comprenant en outre l'étape de réalisation à la surface de ladite couche de matériau plus dur, de rainures concentriques espacées les unes des autres et dont la profondeur ne dépasse 10 nm (100 angstroms).

12. Procédé de fabrication d'un support d'enregistrement magnétique à film mince selon la revendication 10, dans lequel l'étape d'application d'une couche de matériau dur comprend l'application d'une couche de nickel au phosphore à la surface du substrat d'aluminium.
